# EUROPÄISCHE PATENTSCHRIFT

(11) **EP 0 536 661 B1**
(45) Veröffentlichungstag und Bekanntmachung des Hinweises auf die Patenterteilung: **10.01.1996**
(21) Anmeldenummer: 92116930.6
(22) Anmeldetag: 02.10.1992
(51) Int. Cl.: H04N 7/00

(54) **Daten-Slicer-Schaltung**
Data slicing circuit
Circuit extracteur de données

(30) Priorität: 11.10.1991 DE 4133765
(43) Veröffentlichungstag der Anmeldung: 14.04.1993
(73) Patentinhaber: SIEMENS AKTIENGESELLSCHAFT, D-80333 München (DE)
(72) Erfinder: Guggenmos, Wolfgang, Dipl.-Ing., W-8950 Kaufbeuren (DE)

(56) Entgegenhaltungen:
- EP-A- 0 421 897
- US-A- 4 656 513
- FUNKSCHAU Nr. 19, 31. Dezember 1977, Seiten 882 - 887 EATON ET AL. 'die grundlagen von teletext und viewdata'

## Beschreibung

Die Erfindung betrifft eine Daten-Slicer-Schaltung zur Abtrennung und Wiedergewinnung von in einem Videosignal enthaltenen digitalen Datensignalen mittels eines aus den digitalen Datensignalen abgeleiteten Schwellwertes, enthaltend: eine Taktabtrennungsschaltung, die einen Ausgang für ein Signal aufweist, das von der Horizontalfrequenz des Videosignales und von der Taktfrequenz und der momentanen Phasenlage des auszuwertenden Datensignals abhängt, wobei die Taktfrequenz von der Übertragungsnorm des auszuwertenden Datensignals abhängig ist, und wobei die Taktabtrennungsschaltung einen Phasendetektor, einen Oszillator mit veränderbarer Frequenz und eine Steuereinheit enthält, durch die mittels eines digitalen Steuersignals der Oszillator derart angesteuert wird, daß in Abhängigkeit von der vom Phasendetektor ermittelten Phasendifferenz zwischen dem Ausgangssignal des Oszillators und dem auszuwertenden Datensignal die Phasenlage des Ausgangssignals des Oszillators an die des auszuwertenden Datensignals angepaßt wird, und eine Schaltungsanordnung zur Datenabtrennung, die einen Ausgang für die binäre Dateninformation des auszuwertenden Datensignals aufweist.

Eine Daten-Slicer-Schaltung ist u.a. aus der europäischen Patentanmeldung EP-A-0 144 457 bekannt. Mit der Thematik von Daten-Slicer-Schaltungen beschäftigen sich die Artikel "Digital VLSI breeds next-generation TV receivers" von Thomas Fischer, Electronics/August 11, 1981, S. 97 bis 104 und "Die Grundlagen von Teletext und Viewdata", 1. und 2.

Teil von D. Eaton und W.A. Montgommery, Funkschau 1977, Heft 18, S. 820 bis 824 und Heft 19, S. 882 bis 887.

Bekannte Daten-Slicer-Schaltungen bestehen aus einer Schaltungsanordnung zur Taktabtrennung, deren Ausgangssignal von der Horizontalfrequenz fH des auszuwertenden Videosignals, von der gewählten Übertragungsnorm und von der momentanen Phasenlage des auszuwertenden Datensignales abhängen. Als derzeitige Übertragungsnormen kommen 525-Zeilen-WST (World System Teletext) für NTSC-Systeme, 625-Zeilen-WST für PAL-Systeme, VPS und Telecaption in Frage. Die Teletext-Taktfrequenz ist in Abhängigkeit von der gewählten Norm für PAL-Systeme, also 625-Zeilen-WST, 444 mal so groß wie die Horizontalfrequenz, für NTSC-Systeme, also 525-Zeilen-WST, 364 mal so groß wie die Horizontalfrequenz, für VPS-Signale ist die Teletext-Taktfrequenz 320 mal so groß wie die Horizontalfrequenz und für Telecaption-Signale ist die Teletext-Taktfrequenz 64 mal so groß wie die Horizontalfrequenz. Bekannte Daten-Slicer-Schaltungen enthalten außerdem üblicherweise eine Eingangs-Interface-Schaltungseinrichtung, die den Gleichanteil des Videoeingangssignales, also des sogenannten FBAS-Signales, abtrennt und beispielsweise durch eine Schaltungsanordnung realsisiert wird, die den Mittelwert des eingehenden FBAS-Signales ermittelt und diesen vom FBAS-Signal subtrahiert. Außerdem enthalten bekannte Daten-Slicer-Schaltungen eine Schaltungsanordnung zur Datenabtrennung, die an ihrem Ausgang die binäre Dateninformation des auszuwertenden Datensignales bereitstellt. Eine nachgeschaltete Demodulatorschaltung kann die von der Schaltungsanordnung zur Datenabtrennung bereitgestellten Daten unter Zuhilfenahme des von der Schaltungsanordnung zur Taktabtrennung bereitgestellten Taktsignales auswerten. Bei bekannten Daten-Slicer-Schaltungsanordnungen enthält die Schaltungsanordnung zur Taktfrequenzgewinnung eine Phasenregelschleife mit einem spannungsgesteuerten Oszillator (VCO).

Bei Auftreten von Datensignalen unterschiedlicher Norm in einem FBAS-Signal ist bei bekannten Daten-Slicer-Schaltungsanordnungen für jede Norm jeweils ein eigener Slicer oder zumindest der wesentliche Teil eines Slicers inclusive dem VCO erforderlich. Dieses Problem tritt auf, wenn ein FBAS-Signal zwei Datensignale enthält, nämlich ein Videotextsignal und ein Video-Programm-Signal VPS, die im Zeitmultiplexverfahren überlagert sind. Außerdem sind für verschiedene Farbsysteme wie z.B. PAL oder NTSC aufgrund der unterschiedlichen Zeilenfrequenz und somit Videotextdatenfrequenz verschiedene Slicer erforderlich.

Aufgabe der Erfindung ist das Bereitstellen einer Daten-Slicer-Schaltung zur Abtrennung und Wiedergewinnung von in einem Videosignal enthaltenen digitalen Datensignal, die auch Datensignale unterschiedlicher Übertragungsnorm, die infolge von Zeitmultiplexübertragung unmittelbar aufeinanderfolgen, sicher abtrennen und wiedergewinnen kann.

Diese Aufgabe wird bei einer Schaltung nach dem Oberbegriff des Anspruchs 1 dadurch gelöst, daß der Phasendetektor einen Nulldurchgangsdetektor enthält, daß als Oszillator ein Zähler verwendet wird, dessen Zählerstand mit einer ihm zugeführten Systemfrequenz um einen Wert in eine von zwei Richtungen bis zu einem Überlaufwert verändert wird, und daß die Ausgangsfrequenz des Oszillators durch die Veränderung des Wertes in Abhängigkeit von dem digitalen Steuersignal gesteuert wird.

Eine günstige Ausgestaltungsform ist Gegenstand des Unteranspruchs.

Im folgenden wird die Erfindung anhand der Figuren näher erläutert. Es zeigt:
- Figur 1: in Form eines Blockschaltbildes eine erfindungsgemäße Daten-Slicer-Schaltungsanordnung;
- Figur 2: eine mögliche Ausgestaltungsform einer Schaltungsanordnung zur Taktrückgewinnung, wie sie in einer Daten-Slicer-Schaltungsanordnung nach Figur 1 verwendet werden kann.

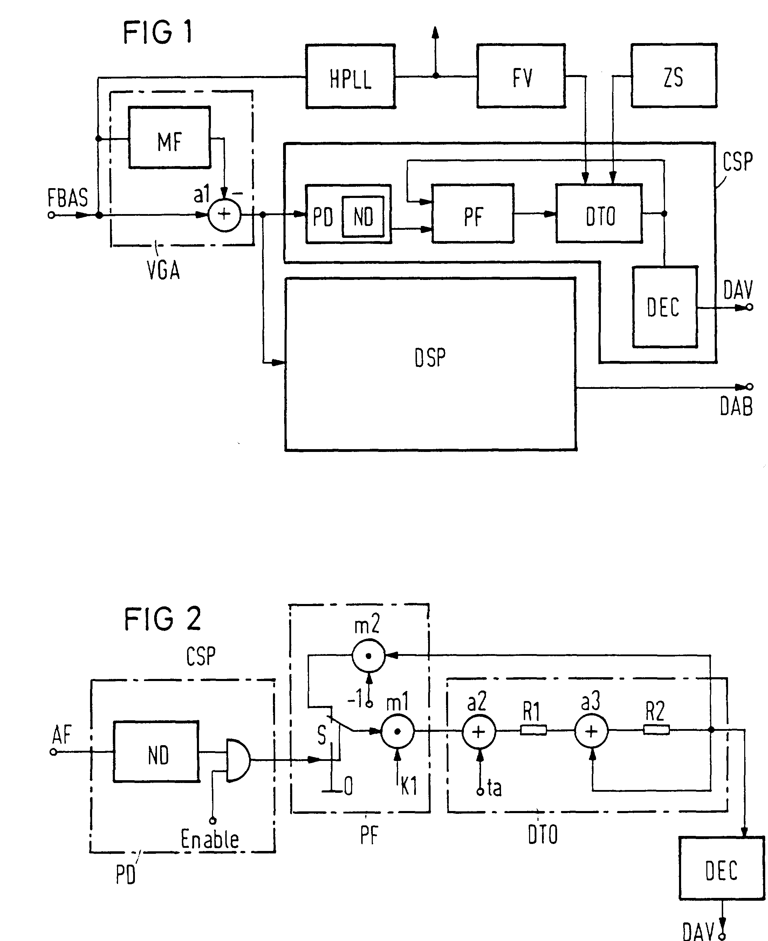

Figur 1 zeigt eine erfindungsgemäße Daten-Slicer-Schaltungsanordnung mit einer Eingangsklemme FBAS zur Einspeisung eines Videosignales, mit einer Vorrichtung VGA zur Extrahierung des Gleichanteiles des Videosignales, mit einer Schaltungsanordnung CSP zur Taktabtrennung und mit einer Schaltungsanordnung DSP zur Datenabtrennung. Außerdem ist in Figur 1 eine Schaltungsanordnung HPLL zur Erzeugung eines Taktsignals gezeigt, das auf die Horizontalfrequenz fH des Videotaktes am FBAS-Signaleingang abgestimmt ist. HPLL ist hierbei eine Abkürzung für Horizontal Phase Locked Loop. In dem gezeigten Ausführungsbeispiel besteht die Schaltungsanordnung VGA zur Extrahierung des Gleichanteiles aus einem Mittelwertfilter MF, das Tiefpaßcharakteristik zeigt und dessen Ausgang als Minuent auf einen Subtraktionspunkt al geschaltet ist, wobei der andere Eingang der Subtraktionsschaltung al mit dem Signaleingang FBAS verbunden ist. Der Signalausgang der Schaltungsanordnung VGA, der in Figur 1 durch den Ausgang der Subtraktionsanordnung al realisiert ist, stellt das Eingangssignal für die Schaltungsanordnung zur Taktabtrennung CSP und für die Schaltungsanordnung zur Datenabtrennung DSP bereit. Als Schaltungsanordnung zur Datenabtrennung DSP kann beispielsweise eine Komparatoranordnung in Form eines Schwellwertschalters vorgesehen sein. Die erfindungsgemäße Schaltungsanordnung CSP zur Taktabtrennung hat an ihrem Signaleingang einen Phasendetektor PD, der einen Nulldurchgangsdetektor ND enthält. Der Ausgang des Phasendetektors PD ist an einen Eingang einer Steuereinheit PF, beispielsweise eines Phasenfilters oder eines Proportional-Reglers, geschaltet. Der Ausgang dieser Steuereinheit PF ist mit einem Steuereingang eines Oszillators DTO (Digital Timing Oszillator) mit veränderbarer Frequenz verbunden. Der Oszillator DTO umfaßt einen Zähler, dessen Zählerstand mit einer ihm zugeführten Systemfrequenz um einen Wert in eine von zwei Richtungen bis zu einem Überlaufwert verändert wird. Die Ausgangsfrequenz des Oszillators DTO wird durch die Veränderung des Wertes in Abhängigkeit von einem digitalen Steuersignal, das von der Steuereinheit PF erzeugt wird, gesteuert. Der Ausgang dieses Oszillators DTO ist an einen weiteren Steuereingang der Steuereinheit PF rückgekoppelt. Außerdem ist der Ausgang dieses Oszillators DTO mit dem Eingang einer Dekoderschaltung DEC zusammengeschaltet, die die Signalfolge am Ausgang des Oszillators DTO in ein Data-Valid-Signal in Form eines Taktsignales umwandelt, und diesen Takt an einer Ausgangsklemme DAV bereitstellt. Der Oszillator DTO kann, wie in Figur 1 gezeigt, von einem Frequenzvervielfacher FV mit der Systemfrequenz angesteuert werden. Der Frequenzvervielfacher ist mit einem auf die Horizontalfrequenz fH des am Eingang FBAS eingespeisten Videosignales abgestimmt. Außerdem kann der Oszillator DTO von einer zentralen Steuereinheit ZS angesteuert werden. Die Schaltungsanordnung zur Datenabtrennung DSP stellt an ihrem Ausgang DAB ein Signal bereit, das die binäre Dateninformation des auszuwertenden Datensignales enthält.

Figur 2 zeigt eine spezielle Ausführungsform der Schaltungsanordnung zur Taktabtrennung CSP aus Figur 1. Der Ausgang des Phasendetektors PD ist in Abhängigkeit von einem Steuersignal über eine Steuereingangsklemme Enable steuerbar. Dadurch wird verhindert, daß der Oszillator DTO mit veränderbarer Frequenz zu Zeiten, in denen systembedingt keine Nulldurchgänge zu erwarten sind, nachgeregelt wird.

Der Signalausgang des Phasendetektors PD ist mit einem Steuereingang der Steuereinheit PF verbunden. Dieser Steuereingang steuert einen Schalter S der einen Eingang eines Multiplizierers m1 in Abhängigkeit von dem vom Phasendetektor PD bereitgestellten Signal entweder an den Ausgang eines weiteren Multiplizierers m2 schaltet oder auf ein einer logischen Null entsprechendes Potential 0. Falls beispielsweise der Steuereingang des Schalters S von einer logischen Null angesteuert wird, wird eine logische Null an den Eingang des Multiplizierers m1 geschaltet. Ein weiterer Eingang des Multiplizierers m1 wird mit einem Koeffizienten K1 beaufschlagt. Der Koeffizient K1 beeinflußt die Zeitdauer, die benötigt wird, bis die Phasenlage des Oszillators DTO an die Phasenlage der Daten des an der Eingangsklemme FBAS eingespeisten Videosignales angepaßt ist. Die Ausregelzeit der aus der Steuereinheit PF und dem Oszillator DTO gebildeten Regeleinheit wird hierbei durch die Veränderung des Koeffizienten K1 variiert. Der Koeffizient K1 wird hierbei in Abhängigkeit von den Nulldurchgängen einer Eingangssequenz des empfangenen Videosignales festgelegt und ist außerdem durch eine zentrale Steuereinheit ZS einstellbar.

Ein Eingang des Multiplizierers m2 bildet den Signaleingang der Steuereinheit PF und ist mit dem Ausgang des Oszillators DTO zusammengeschaltet. Der Multiplizierer m2 ist an einem weiteren Eingang derart beschaltet, daß er das an dem Signaleingang der Steuereinheit PF anliegende Signal mit dem festen Faktor -1 multipliziert. Die Anordnung aus Multiplizierer m1, Multiplizierer m2 und Schalter S und ihre Beschaltung bilden ein Phasenfilter PF. Der Ausgang des Multiplizierers m1 bildet den Signalausgang des die Steuereinheit bildenden Phasenfilters PF und ist mit einem Steuereingang des Oszillators DTO zusammengeschaltet.

In dem gezeigten Ausführungsbeispiel besteht der Oszillator DTO aus einem Addierer a2, der zu einem von dem Phasenfilter PF bereitgestellten Eingangswert einen festen Wert ta addiert. Der Ausgang dieses Addierers a2 ist mit dem Eingang eines Registers R1 verbunden, in dem die Ausgangsgröße des Addierers a2 um einen Taktzyklus verzögert wird. Der Ausgang des Registers R1 ist mit einem Eingang eines Addierers a3 verbunden. Der Ausgang dieses Addierers a3 ist mit dem Eingang eines weiteren Registers R2 verbunden, das wiederum den von dem Addierer a3 bereitgestellten Wert um einen Taktzyklus verzögert an einen Ausgang weitergibt. Der Ausgang des Registers R2 ist mit dem Signaleingang der Steuereinheit PF, mit einem zweiten Eingang des Addierers a3 und mit dem Signaleingang einer Dekoderschaltung DEC verbunden. Die in Figur 2 gezeigte Anordnung, bestehend aus den beiden Addiererschaltungen a2 und a3 und den beiden Registern R1 und R2 entsprechen einer üblichen Schaltungsanordnung eines digitalen Oszillators. Bei der gezeigten Schaltungsanordnung wird die Frequenz des Oszillators für den Fall, daß die Steuereinheit PF keinen Signalanteil liefert, von dem festen Wert ta, von der Überlaufcharakteristik des Addierers a3 und von der Taktfrequenz des Systemes bestimmt. Durch die entsprechende Ansteuerung des Oszillators DTO von der Steuerschaltung PF in Abhängigkeit von dem Phasendetektor PD wird die Phase des Ausgangssignales des Oszillators DTO auf die Phasenlage der Daten des Videosignales synchronisiert. Die Dekoderschaltung DEC erzeugt aus dem Ausgangssignal des Oszillators DTO ein Data-Valid-Signal in Form eines Taktsignales, wobei dieses Taktsignal von einer bestimmten Phasenlage des Oszillators abhängig ist.

## Patentansprüche

1. Daten-Slicer-Schaltung zur Abtrennung und Wiedergewinnung von in einem Videosignal enthaltenen digitalen Datensignalen mittels eines aus den digitalen Datensignalen abgeleiteten Schwellwertes, enthaltend:
eine Taktabtrennungsschaltung (CSP), die einen Ausgang (DAV) für ein Signal aufweist, das von der Horizontalfrequenz (fH) des Videosignales und von der Taktfrequenz und der momentanen Phasenlage des auszuwertenden Datensignals abhängt, wobei die Taktfrequenz von der Übertragungsnorm des auszuwertenden Datensignals abhängig ist, und wobei die Taktabtrennungsschaltung einen Phasendetektor (PD), einen Oszillator (DTO) mit veränderbarer Frequenz und eine Steuereinheit (PF) enthält, durch die mittels eines digitalen Steuersignals der Oszillator (DTO) derart angesteuert wird, daß in Abhängigkeit von der vom Phasendetektor (PD) ermittelten Phasendifferenz zwischen dem Ausgangssignal des Oszillators (DTO) und dem auszuwertenden Datensignal die Phasenlage des Ausgangssignals des Oszillators (DTO) an die des auszuwertenden Datensignals angepaßt wird, und eine Schaltungsanordnung zur Datenabtrennung (DSP), die einen Ausgang (DAB) für die binäre Dateninformation des auszuwertenden Datensignals aufweist,
**dadurch gekennzeichnet**,
daß der Phasendetektor (PD) einen Nulldurchgangsdetektor (ND) enthält, daß als Oszillator (DTO) ein Zähler verwendet wird, dessen Zählerstand mit einer ihm zugeführten Systemfrequenz um einen Wert in eine von zwei Richtungen bis zu einem Überlaufwert verändert wird, und daß die Ausgangsfrequenz des Oszillators (DTO) durch die Veränderung des Wertes in Abhängigkeit von dem digitalen Steuersignal gesteuert wird.

2. Daten-Slicer-Schaltung nach Anspruch 1, mit einer Schaltungsanordnung (HPLL) zur Erzeugung eines Taktsignales, das auf die Horizontalfrequenz (fH) des Videosignales bezüglich Frequenz und Phase abgestimmt ist,
**dadurch gekennzeichnet**,
daß die Systemfrequenz von einem Frequenzvervielfacher (FV) geliefert wird, durch den die Frequenz des Taktsignales, das von der Schaltungsanordnung (HPLL) zur Erzeugung des auf die Horizontalfrequenz (fH) abgestimmten Taktsignales erzeugt wird, um einen Vervielfachungswert vervielfacht wird.

## Claims

1. Data slicer circuit for separating and recovering digital data signals, which are contained in a video signal, by means of a threshold value which is derived from the digital data signals, containing:
a clock separation circuit (CSP) which has an output (DAV) for a signal which depends on the horizontal frequency (fH) of the video signal and on the clock frequency and the instantaneous phase angle of the data signal to be evaluated, the clock frequency being dependent on the transmission standard of the data signal to be evaluated and the clock separation circuit containing a phase detector (PD), a variable frequency oscillator (DTO) and a control unit (PF) by which the oscillator (DTO) is driven by means of a digital control signal in such a manner that the phase angle of the output signal of the oscillator (DTO) is matched to that of the data signal to be evaluated as a function of the phase difference, which is determined by the phase detector (PD), between the output signal of the oscillator (DTO) and the data signal to be evaluated, and a circuit arrangement for data separation (DSP) which has an output (DAB) for the binary data information of the data signal to be evaluated, characterized in that the phase detector (PD) contains a zero crossing detector (ND), in that a counter is used as the oscillator (DTO), whose count is changed at a system frequency which is applied to it by a value in one of two directions as far as an overflow value, and in that the output frequency of the oscillator (DTO) is controlled by changing the value as a function of the digital control signal.

2. Data slicer circuit according to Claim 1, having a circuit arrangement (HPLL) for producing a clock signal which is matched to the horizontal frequency (fH) of the video signal in terms of frequency and phase, characterized in that the system frequency is supplied by a frequency multiplier (FV) by means of which the frequency of the clock signal is multiplied by a multiplication value, said clock signal being produced by the circuit arrangement (HPLL) for producing the clock signal which is matched to the horizontal frequency (fH).

## Revendications

1. Circuit éminceur de données servant à séparer et récupérer des signaux de données numériques, qui sont contenus dans un signal vidéo, à l'aide d'une valeur de seuil dérivée des signaux de données numériques, et contenant :
un circuit de séparation de cadence (CSP), qui comporte une sortie (DAV) pour un signal, qui dépend de la fréquence horizontale (fH) du signal vidéo et de la fréquence de cadence et de la position de phase instantanée du signal de données devant être évalué, la fréquence de cadence dépendant de la norme de transmission du signal de données devant être évalué, le circuit de séparation de cadence comprenant un détecteur de phase (PD), un oscillateur (DTO) à fréquence variable et une unité de commande (PF), au moyen de laquelle l'oscillateur (DTO) est commandé au moyen d'un signal de commande numérique de telle sorte qu'en fonction de la différence de phase, déterminée par le détecteur de phase (PD), entre le signal de sortie de l'oscillateur (DTO) et le signal de données devant être évalué, la position de phase du signal de sortie de l'oscillateur (DTO) est adaptée à celle du signal de données devant être évalué, et comporte un montage (DSP) pour la séparation de données, qui comporte une sortie (DAB) pour l'information de données binaires du signal de données devant être évalué,
caractérisé par le fait
que le détecteur de phase (PD) comprend un détecteur de passages par zéro (ND), qu'on utilise comme oscillateur (DTO) un compteur, dont l'état de comptage est modifié, à une fréquence du système qui lui est envoyée, d'une valeur dans
l'une des deux directions, jusqu'à une valeur de dépassement de capacité, et que la fréquence de sortie de l'oscillateur (DTO) est commandée par la modification de la valeur en fonction du signal de commande numérique.

2. Circuit éminceur de données selon la revendication 1, comportant un montage (HPLL) pour produire un signal de cadence, dont la fréquence et la phase sont accordées sur la fréquence horizontale (fH) du signal vidéo,
caractérisé par le fait que la fréquence du système est délivrée par un multiplicateur de fréquence (FV), au moyen duquel la fréquence du signal de cadence, qui est produit par le montage (HPLL) servant à produire le signal de cadence accordé sur la fréquence horizontale (fH), est multiplée par un facteur multiplicatif.
